(19)

Europäisches
Patentamt

European
Patent Office

Office européen
des brevets

(11)  **EP 3 642 636 B1**

(12)  # EUROPEAN PATENT SPECIFICATION

(45) Date of publication and mention
of the grant of the patent:
**04.08.2021  Bulletin 2021/31**

(51) Int Cl.:
*G01R 19/25* (2006.01)      *G01R 22/06* (2006.01)
*G01R 27/16* (2006.01)

(21) Application number: **18733594.8**

(86) International application number:
**PCT/EP2018/066774**

(22) Date of filing: **22.06.2018**

(87) International publication number:
**WO 2018/234550 (27.12.2018 Gazette 2018/52)**

(54) **METHOD FOR DETECTING IMPEDANCES IN AN ELECTRICAL POWER DISTRIBUTION GRID**

VERFAHREN ZUR ERFASSUNG VON IMPEDANZEN IN EINEM ELEKTRISCHEN STROMVERTEILUNGSNETZ

PROCÉDÉ DE DÉTECTION D'IMPÉDANCES DANS UNE RÉSEAU DE DISTRIBUTION D'ÉNERGIE ÉLECTRIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority:  **23.06.2017  EP 17382392**

(43) Date of publication of application:
**29.04.2020  Bulletin 2020/18**

(73) Proprietor: **Ariadna Instruments, S.L.**
**48340 Amorebieta (ES)**

(72) Inventor: **HARITZ, Zubia Urrutia**
**48940 Leioa (Bizkaia) (ES)**

(74) Representative: **Juncosa Miró, Jaime et al**
**Torner, Juncosa i Associats, S.L.**
**C/Pau Claris, 108, 1r 1a**
**08009 Barcelona (ES)**

(56) References cited:
**US-A1- 2014 244 065     US-A1- 2016 047 851**

• **YANG J ET AL: "Online estimation and application of power grid impedance matrices based on synchronised phasor measurements", IET GENERATION, TRANSMISSION & DISTRIBU,, vol. 4, no. 9, 6 September 2010 (2010-09-06), pages 1052-1059, XP006036237, ISSN: 1751-8695, DOI: 10.1049/IET-GTD:20100021**

**Description**

Field of the Art

The present invention relates to an automated method implemented by means of a computing device acting as a supervisor for detecting impedances in an electrical power distribution grid, from a head-end point (transformer or distribution line) to a plurality of user meters or customers of a utility company.

Prior State

Patent application US-A1-20150241488 discloses techniques for detecting when electricity is stolen by bypassing an electric meter. In one embodiment, a time-series of voltage changes and current changes associated with the electrical consumption measured in a meter are obtained. The time-series may track voltage and current changes associated with short intervals (for example, 5 minutes). An analysis (for example, a regression analysis) may be performed on the voltage changes against the current changes. Also, by using the correlation from the analysis, it may be determined if the meter was bypassed.

Patent document CN-B-102095911 discloses a smart electric meter based on impedance identification. The meter has a voltage transducer and a current transducer for precisely detecting a monitoring point. The power consumption information for a specified load is supervised to obtain the load impedance value, wherein the value is stored in a memory. The obtained impedance value is compared with the stored impedance value and an indication is received if the two values are identical.

International patent application WO-A1-2015179908 relates to an automated process for monitoring and evaluating the integrity of an active line and/or neutral line for a polyphase site. The process uses measurements obtained at the site to estimate the voltage and impedance of the neutral line. These estimates are compared with established operating zones for the site to evaluate the condition of the active and/or neutral line. An electrical utility meter installed at the site captures instantaneous usage measurements (typically the voltage and current for each phase of an electrical supply). The measurements are transmitted to an evaluation module that derives active and/or neutral line performance characteristics.

US-A1-2016047851 relate to a method for the computer-aided ascertainment of the impedance of an electrical energy network, wherein the electrical voltage, the active power, and the reactive power are measured at a connection point, by which an electrical energy production installation is connected to the energy network, at respective successive instants. In this case, the impedance value is estimated at respective present instants by a computation code that is independent of the phase of the measured voltage. The estimation is carried out only for relatively large variations in the measured voltage or reactive power. The estimate is also taken into account only if its estimate error is small. In this patent application the variations are due to the power generation installation, caused by the electrical energy generator. On the contrary, in the present invention Thevenin's impedance calculation is based on changes in power consumption due to the user/customer who is connected downstream of the grid connection point, which is due to its connection load.

None of the aforementioned prior art documents allows determining the impedance of an electrical power distribution grid from measurements taken by each electrical power meter of grid users, i.e., the resistance and reactance of the segment of cable going from the utility company's transformer to the meter.

Description of the Invention

Embodiments of the present invention provide a method for detecting impedances in an electrical power distribution grid, wherein the mentioned electrical power distribution grid comprises a supply transformer (it may include more than one) which has associated therewith one or more electrical power distribution lines, each electrical power distribution line in turn having associated therewith one or several electrical power distribution nodes for distributing power to users and one or several electrical power user meters.

Unlike known proposals in the prior art, the proposed method comprises performing the following steps using at least one of said meters:

a) said meter measuring a first RMS voltage VM1 value, a first RMS current IM1 value and a first power factor PF1 value in said meter at a first time $t_1$, said VM1, IM1 and PF1 values being measured in the meter due to a power consumption caused by loads connected to the meter;

b) said meter measuring a second RMS voltage VM2 value, a second RMS current IM2 value and a second power factor PF2 value in the meter at a second time $t_2$ in which a variation in power consumption caused by loads connected to the meter is detected with respect to said first time $t_1$ in said meter; and

c) a computing device running an algorithm that determines a value of the equivalent grid impedance ZTH from the transformer to the meter taking the following into consideration:

c1) the equivalent grid impedance ZTH is similar to the grid impedance calculated according to Thevenin's theorem;

c2) the line head-end voltage according to Thevenin's theorem VTH remains unchanged at said first and second times $t_1$, $t_2$;

c3) the Thevenin voltage VTH provides a voltage at said first time as a result of implementing the following expression: ZTH*IM1 + VM1, and a voltage at said second time as a result of implementing the following expression: ZTH*IM2 + VM2; and

c4) the RMS voltages VM and RMS currents IM include complex terms due to the alternating current grid VM = VM*cos(a) + VM*sin(a)*j, and IM = IM*cos(b) + IM*sin(b)*j, wherein (a) is the angle between VTH and VM, and its value is close to zero, and b is the angle between VTH and IM, and its value is close to a value of the power factor PF at times $t_1$, $t_2$ measured by the meter, wherein said algorithm implements the following expression: ZTH = (VM1 - VM2) / (IM2-IM1), extracted from c3) and c4); and

d) repeating steps a) to c) for subsequent time intervals and implementing a statistical adjustment procedure of the ZTH determined values until a ZTH value converges to a given value that is taken as the equivalent grid impedance ZTH from the transformer (10) to the meter (13).

The acquisition of said first and second RMS voltage and current VM1, VM2, IM1, IM2 values and power factor PF1, PF2 values measured by the meter, and the running of the algorithm are performed automatically by means of the intervention of the mentioned computing device, which receives or accesses said data.

In one embodiment, the algorithm is applied to each of the meters of a given electrical power distribution line.

The computing device, for example a computer, laptop, tablet, among others, is preferably a device of a control center, having a connection to a communication module of the mentioned meter/meters.

In situations where there is distributed generation, i.e., there are several sources providing electrical power to the grid, the equivalent grid impedance feeding a given meter is no longer just that which corresponds to the transformer and grid segment going from the transformer to the meter, but rather it will be reduced by the new power source/sources. However, since the meter for which the grid impedance ZTH is to be obtained, it does not have the ability to know, with just the data it measures, if the power it receives comes from just the utility company's transformer or from an additional source of distributed generation. Calculations must be performed at a place where the energy flux in the power grid is known, in the instants in which the source of power comes from the power supply transformer alone.

The mentioned computing device of a control center can therefore calculate the equivalent impedance ZTH with the RMS voltage and RMS current VM1, VM2, IM1, IM2 values and power factor PF1, PF2 values measured by the meter/meters corresponding to times/instants $t_1$ and $t_2$ in which there is no additional incoming power in the meter/meters other than the power supplied by the transformer (i.e., ZTH can be calculated with just the values of the instants in which there is no distributed generation in the electrical power distribution line).

In one embodiment, the mentioned RMS voltage, RMS current and power factor values measured by the meter/meters are stored in a memory (or database) of the control center.

The mentioned equivalent impedance ZTH for each of the meters varies according to the grid component provided by the segment having a different distance, types of cable (material, section) and length thereof, and state of the conductor from the transformer to the meter.

If there are different types of junctions, sections and lengths of cable along the path between the transformer and the meter, impedance ZTH will be the sum of the impedance of each grid segment.

If the conductor experiences changes in state over time due to faults, poorly clamped junctions which gradually wear, etc., the impedance value will be affected.

In one embodiment, the method further comprises connecting an electric voltage measuring apparatus to the transformer, or to at least one electrical power distribution line, and said measuring apparatus measuring a first RMS voltage VT1 value at the first time $t_1$ and a second RMS voltage VT2 value at the second time $t_2$ of the head-end of the grid (transformer or line). Therefore, in this embodiment the algorithm in c3) also takes into consideration the mentioned voltage VT1 and VT2 values measured by the measuring apparatus, such that the voltage VTH provides a voltage at the first time as a result of implementing the following expression: ZTH * IM1 + (VM1-VT1), and a voltage at said second time as a result of implementing the following expression: ZTH * IM2 + (VM2-VT2), the algorithm implementing the following expression: ZTH = ((VM1-VT1) - (VM2-VT2)) / (IM2-IM1).

Therefore, the proposed method allows calculating the equivalent grid impedance either including just the data measured by a specific meter, or else in a second, more complex version which nonetheless calculates the data beforehand because voltage variation noises from the medium voltage (MV) are removed, which version combines the user/customer meter data and the grid head-end (transformer or line) data to calculate the mentioned impedance.

This calculation system is based on detecting the voltage variations which occur due to measured power/electrical consumption changes caused by different loads connected to the grid at different times and can be measured by the customer's meter with which they are associated. Since the voltage variations caused by these changes are generally very small, it is particularly important for the measured voltage variations to be the consequence of the detected power/electrical consumption change, and not due to other loads connected to/disconnected from the grid. The variations in the load connected to the electric power system in other low voltage lines (LV) of the same transformer, or in the rest of the medium voltage (MV) and even high voltage (HV) grid cause voltage variations which are noticeable at the point where the meter is connected. In fact, most voltage variations existing in the grid in reality are the result of the sum of loads connected throughout the electrical power distribution grid, whether it is HV, MV or LV.

In order to filter out external noises to the greatest extent possible, the invention provides a method in which the mentioned voltage measuring apparatus helps to clean up the noises that make it difficult to calculate grid impedance ZTH.

The proposed method uses real measurements of a smart electric current meter, and also, optionally, of the head-end of the grid (transformer or line), to determine the grid impedance data. Therefore they are real, not calculated, measurements.

The detected grid impedance can serve to: detect the sequence of meters in the grid; calculate technical grid losses, and thereby improve those locations with huge losses or more precisely detect someone stealing; improve the utility company's inventory (some companies calculate the impedance value according to their grid inventory, including lengths of cable, sections, etc.; an inconsistency between this calculation and the value measured with the proposed invention would be indicative of inventory errors); monitor the impedance value over time and prevent faults, as well as locate fault segments in the grid, such as breaking of the neutral conductor; detect poorly clamped cables; calculate grid voltage drops; calculate conductor current saturations; determine the impedance of a connection before the meter to help locate the position thereof along the electrical power distribution line, etc.

## Brief Description of the Drawings

The foregoing and other advantages and features will be better understood from the following description detailed of the embodiments in reference to the attached drawings, which are to be interpreted in an illustrative and non-limiting manner, in which:

Figure 1 schematically shows a typical example of a low-voltage electrical power distribution grid feeding multiple users/customers.

Figures 2A and 2B show a circuit equivalent to a low-voltage grid.

Figure 3 is a flow chart of a method for detecting impedances in an electrical power distribution grid according to a embodiment of the present invention.

Figure 4 is a flow chart of a method for detecting impedances in an electrical power distribution grid according to another embodiment of the present invention.

## Detailed Description of the Embodiments

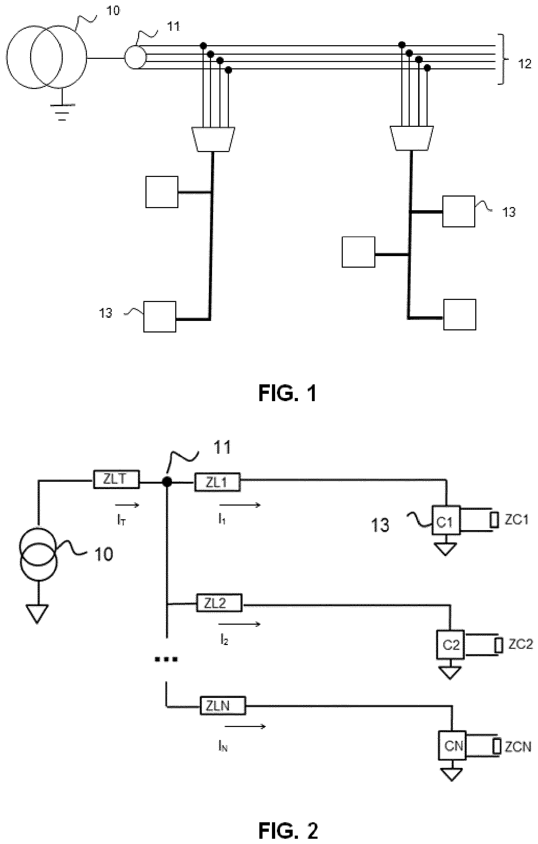

Figure 1 schematically illustrates a low-voltage electrical power distribution grid in which grid impedance is to be measured. The mentioned electrical power distribution grid includes a supply transformer 10 which has one or more electrical power distribution lines 12 associated therewith (this example shows a three-phase line with a neutral conductor). Each distribution line also has an associated node 11, being able to have more than one, for distributing electrical power to users and several electrical power meters 13.

Figure 2A shows a circuit equivalent to the electrical power distribution grid of Figure 1 which is proposed for implementing the present invention, wherein ZLT is the common grid impedance from a low-voltage line to the mentioned node 11; ZLN is the particular impedance of the grid segment going from the node 11 to a given meter 13; and ZCN is the impedance of the load connected downstream of each meter 13.

The objective is to calculate the grid impedance seen from any meter 13. Therefore, the application of Thevenin's theorem is envisaged to simplify the equivalent circuit of Figure 2A (see Figure 2B). By analyzing the impedances of the circuit to calculate ZTH, the condition ZC >> ZL is met, i.e., the impedances of the loads connected to the meters 13 are always much higher than the impedances of the grid, as can be expected. Therefore if the impedances are simplified according to Thevenin, the condition ZTH = ZLT + ZLN is met, i.e., the grid impedance seen from any meter 13 is the same as Thevenin's impedance, so any electrical distribution circuit can be simplified into a VTH and a ZTH.

Furthermore, if measurements are taken in the instant in which there is a variation in ZC, i.e., when a load that can be detected by the meter 13 is connected or disconnected, the voltage of the transformer 10 does not change (because the impedance of the transformer 10 is very low), and only the current I, VM and ZC change. That is useful because the grid impedance can thus be calculated with equations where impedance ZC is not present.

Therefore, at two times 1 and 2:

$$VTH = ZTH * IM1 + VM1$$

$$VTH = ZTH * IM2 + VM2$$

$$ZTH = (VM1 - VM2) / (IM2 - IM1).$$

By introducing the complex terms due to the alternating current grid:

$$VM = VM*cos(a) + VM*sin(a)*j$$

$$IM = IM*\cos(b) + IM*\sin(b)*j$$

wherein: (a) is the angle between VTH and VM, and its value is close to zero, and b is the angle between VTH and IM, and its value is close to a value of the power factor PF at times $t_1$, $t_2$ measured by the meter 13. An equation (which can be simplified) calculating the grid impedance seen from a given meter 13, with measurements of VM, IM and power factor, is thereby obtained.

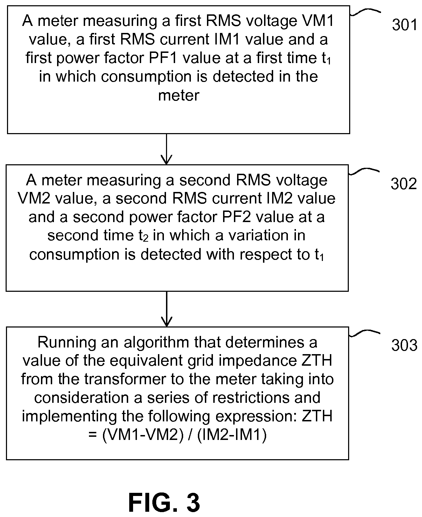

Now in relation to Figure 3, it shows an embodiment of a method for detecting impedances in the electrical power distribution grid, in which only data measured by any specific meter 13 is used. First the method comprises, in step 301, one of the mentioned meters 13 measuring, at a first time $t_1$ in which power consumption caused by loads is detected in the meter 13, a first RMS voltage VM1 value, a first RMS current IM1 value and a first power factor PF1 value. Then, in step 302, the meter 13 measures, at a second time $t_2$ in which a variation in power consumption caused by loads is detected with respect to said first time $t_1$, a second RMS voltage VM2 value, a second RMS current IM2 value and a second power factor PF2 value. Next, in step 303, a computing device (not illustrated for the sake of simplicity of the drawings), which receives or has access to the RMS voltage and RMS current VM1, VM2, IM1, IM2, and power factor PF1, PF2 data measured by the meter 13 and corresponding to times $t_1$ and $t_2$, runs an algorithm that determines a value of the equivalent grid impedance ZTH from the transformer 10 to the meter 13.

The mentioned algorithm takes the following restrictions/conditions into account: the equivalent grid impedance ZTH is similar to the grid impedance calculated according to Thevenin's theorem (as explained above); the line head-end voltage according to Thevenin's theorem VTH remains unchanged at said first and second times $t_1$, $t_2$; the Thevenin voltage VTH provides a voltage at the first time as a result of implementing the following expression: ZTH * IM1 + VM1, and a voltage at the second time as a result of implementing the following expression: ZTH * IM2 + VM2; and the RMS voltages VM and RMS currents IM include complex terms due to the alternating current grid, such that the algorithm implements the following expression: ZTH = (VM1 - VM2) / (IM2-IM1) for detecting (measuring) the impedance in the electrical power distribution grid.

Moreover, steps 301-303 are repeated for subsequent time intervals, implementing a statistical adjustment procedure of the different ZTH determined values until a ZTH value converges to a given value, being this value the value that is taken as the equivalent grid impedance ZTH.

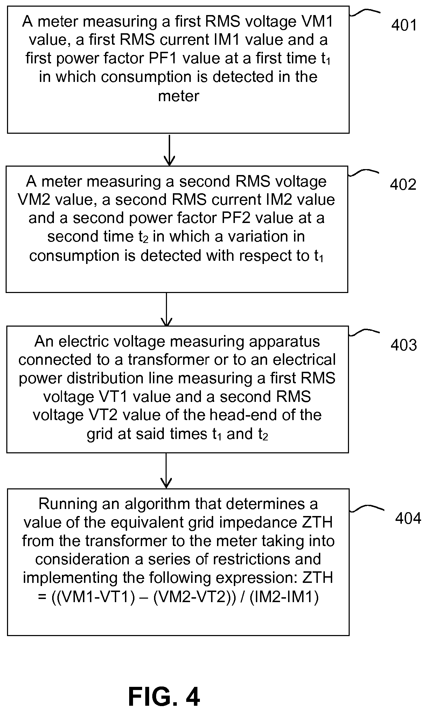

Now in relation to Figure 4, it shows another embodiment of a method for detecting impedances in the electrical power distribution grid, wherein in this case, in addition to the data measured by a meter 13 the grid head-end data is also taken into account. To that end, an electric voltage measuring apparatus (not illustrated) is connected in the transformer 10 or in one of the electrical power distribution lines (it can be connected to more than one of the lines). Unlike the method above in relation to Figure 3, in this embodiment at the same time the meter 13 measures the RMS voltage and RMS current VM1, VM2, IM1, IM2, and the power factors PF1, PF2 at the mentioned times $t_1$ and $t_2$, the mentioned electric voltage measuring apparatus measures, in step 403, a first RMS voltage VT1 value at the first time $t_1$ and a second RMS voltage VT2 value at the second time $t_2$ of the grid head-end.

Once all the measured data is available, in step 404 the computing device runs an algorithm that determines a value of the equivalent grid impedance ZTH from the transformer 10 to the meter 13. The algorithm in this case also takes into consideration the mentioned voltage VT1 and VT2 values measured by the measuring apparatus, such that ZTH = ((VM1-VT1) - (VM2-VT2)) / (IM2-IM1).

The computing device is preferably a device of a control center, for example of the utility company operating the distribution grid, including one or more processors and at least one memory or database, and having a preferably wireless connection with a communication module of the meter 13.

The computing device can calculate the equivalent impedance ZTH with the RMS voltage and RMS current VM1, VM2, IM1, IM2 values and power factor PF1, PF2 values measured by the meter 13 corresponding to times $t_1$ and $t_2$ in which there is no additional incoming power in the meter 13 other than the power supplied by the transformer 10.

The proposed method can be implemented in any of the described embodiments in each of the meters 13 of a given electrical power distribution line.

The scope of the invention is defined in the attached claims.

## Claims

1. A method for detecting impedances in an electrical power distribution grid, wherein said electrical power distribution grid comprises at least one supply transformer (10) which has one or more electrical power distribution lines (12) associated therewith, each electrical power distribution line (12) having associated therewith one or several electrical power distribution nodes (11) for distributing power to users and one or several electrical power user meters (13), **characterized in that** the method comprises the following steps using at least one of said electrical power meters and a computing device:

   a) the meter (13) measuring a first RMS voltage VM1 value, a first RMS current IM1 value and a first power factor PF1 value in said meter (13) at a first time $t_1$, said VM1, IM1 and PF1 values being measured in the meter (13) because of a power consumption caused by loads connected to the meter (13);

b) the meter (13) measuring a second RMS voltage VM2 value, a second RMS current IM2 value and a second power factor PF2 value in said meter (13) at a second time $t_2$, in which a variation in power consumption caused by loads connected to the meter (13) is detected with respect to said first time $t_1$ in said meter (13); and

c) running an algorithm that determines a value of the equivalent grid impedance ZTH from said transformer (10), which is at least one in number, to the meter (13) taking the following into consideration:

c1) the equivalent grid impedance ZTH is similar to the grid impedance calculated according to Thevenin's theorem;

c2) the line head-end voltage according to Thevenin's theorem VTH remains unchanged at said first and second times $t_1$, $t_2$;

c3) the Thevenin voltage VTH provides a voltage at said first time $t_1$ as a result of implementing the following expression: ZTH * IM1 + VM1, and a voltage at said second time $t_2$ as a result of implementing the following expression: ZTH * IM2 + VM2; and

c4) the RMS voltages VM and RMS currents IM include complex terms due to the alternating current grid VM = VM*cos(a) + VM*sin(a)*j, and IM = IM*cos(b) + IM*sin(b)*j, wherein (a) is the angle between VTH and VM, and its value is close to zero, and b is the angle between VTH and IM, and its value is close to a value of the power factor PF at times $t_1$, $t_2$ measured by the meter (13),

wherein said algorithm implements the following expression: ZTH = (VM1 - VM2) / (IM2-IM1), extracted from c3) and c4); and

d) repeating steps a) to c) for subsequent time intervals and implementing a statistical adjustment procedure of the ZTH determined values until a ZTH value converges to a given value that is taken as the equivalent grid impedance ZTH from the transformer (10) to the meter (13), and

wherein the acquisition of said first and second RMS voltage and current VM1, VM2, IM1, IM2 values and power factor PF1, PF2 values measured by the meter (13), and the running of the algorithm are performed automatically by means of said computing device, which receives, or accesses said data.

2. The method according to claim 1, wherein said computing device is a device of a control center, having a connection to a communication module of the meter (13).

3. The method according to claim 2, wherein said computing device of a control center calculates the equivalent impedance ZTH with the RMS voltage and RMS current VM1, VM2, IM1, IM2 values and power factor PF1, PF2 values measured by the meter (13) corresponding to times $t_1$ and $t_2$ in which there is no additional incoming power in the meter (13) other than the power supplied by the transformer (10).

4. The method according to claim 1, wherein said algorithm is applied to each of the meters (13) of a given distribution line.

5. The method according to claim 4, wherein said computing device is a device of a control center, having a connection to a communication module of each of the meters (13) of a given electrical power distribution line.

6. The method according to claim 5, wherein said computing device of a control center calculates the equivalent impedance ZTH with the RMS voltage and RMS current VM1, VM2, IM1, IM2 values and power factor PF1, PF2 values measured by each of the meters (13) of said given distribution line, corresponding to times $t_1$ and $t_2$ in which there is no additional incoming power in the meter (13) other than the power supplied by the transformer (10).

7. The method according to claim 5, wherein the mentioned RMS voltage, RMS current and power factor values measured by the meters (13) are stored in a memory of said control center.

8. The method according to claim 6, wherein the equivalent impedance ZTH for each of the meters (13) varies according to the grid component provided by the segment having a different distance, types of cable, and state of the conductor from the transformer (10) to the meter (13).

9. The method according to claim 1, **characterized in that** it further comprises:

connecting an electric voltage measuring apparatus to said transformer (10), which is at least one in number, or to at least one electrical power distribution line (12);

said measuring apparatus measuring a first RMS voltage VT1 value at the first time $t_1$ and a second RMS voltage VT2 value at the second time $t_2$; and

taking said first and second RMS voltage VT1, VT2 values measured into consideration in c3), such that the Thevenin voltage VTH provides at the first time a voltage as a result of implementing the following expression: ZTH * IM1 + (VM1-VT1) and a voltage at said second time as a result of implementing the following expression: ZTH * IM2 + (VM2-VT2),

wherein the algorithm implements the following expression: ZTH = ((VM1-VT1) - (VM2-VT2)) / (IM2-IM1).

**Patentansprüche**

1. Verfahren zur Erfassung von Impedanzen in einem elektrischen Stromverteilungsnetz, wobei das elektrische Stromverteilungsnetz mindestens einen Versorgungstransformator (10) umfasst, dem eine oder mehrere elektrische Stromverteilungsleitungen (12) zugeordnet sind, wobei jeder elektrischen Stromverteilungsleitung (12) ein oder mehrere elektrische Stromverteilungsknoten (11) zur Verteilung von Strom an Verbraucher und ein oder mehrere elektrische Stromverbrauchszähler (13) zugeordnet sind, **dadurch gekennzeichnet, dass** das Verfahren folgende Schritte umfasst, wobei mindestens eines der elektrischen Stromzähler und eine Rechnervorrichtung verwendet werden:

   a) der Zähler (13) misst einen ersten RMS-Spannungswert VM1, einen ersten RMS-Stromwert IM1 und einen ersten Leistungsfaktor-Wert PF1 in dem Zähler (13) zu einem ersten Zeitpunkt $t_1$, wobei die VM1-, IM1- und PF1-Werte in dem Zähler (13) aufgrund eines durch an den Zähler (13) angeschlossene Verbraucher verursachten Stromverbrauchs gemessen werden;
   b) der Zähler (13) misst einen zweiten RMS-Spannungswert VM2, einen zweiten RMS-Stromwert IM2 und einen zweiten Leistungsfaktor-Wert PF2 in dem Zähler (13) zu einem zweiten Zeitpunkt $t_2$, wo eine Änderung des Stromverbrauchs, der durch an den Zähler (13) angeschlossene Verbraucher verursacht wird, in Bezug auf den ersten Zeitpunkt $t_1$ in dem Zähler (13) erfasst wird; und
   c) ein Algorithmus wird ausgeführt, der einen Wert der äquivalenten Netzimpedanz ZTH von dem mindestens einen Transformator (10) zu dem Zähler (13) bestimmt, wobei Folgendes berücksichtigt wird:

      c1) die äquivalente Netzimpedanz ZTH ist ähnlich der gemäß dem Thevenin-Theorem berechneten Netzimpedanz;
      c2) die Leitungskopfspannung gemäß dem Thevenin-Theorem VTH bleibt zum ersten und zweiten Zeitpunkt $t_1$, $t_2$ unverändert;

      c3) die Thevenin-Spannung VTH liefert eine Spannung zum ersten Zeitpunkt $t_1$ als Ergebnis der Implementierung des folgenden Ausdrucks: ZTH * IM1 + VM1, und eine Spannung zum zweiten Zeitpunkt $t_2$ als Ergebnis der Implementierung des folgenden Ausdrucks: ZTH * IM2 + VM2; und
      c4) die RMS-Spannungen VM und die RMS-Ströme IM schließen komplexe Terme aufgrund des Wechselstromnetzes ein VM = VM*cos(a) + VM*sin(a)*j und IM = IM*cos(b) + IM*sin(b)*j, wobei (a) der Winkel zwischen VTH und VM ist und sein Wert nahe bei Null liegt, und b der Winkel zwischen VTH und IM ist und sein Wert nahe bei einem Wert des Leistungsfaktors PF zu den Zeitpunkten $t_1$, $t_2$ liegt, der von dem Zähler (13) gemessen wird,
      wobei der Algorithmus den folgenden Ausdruck implementiert: ZTH = (VM1 - VM2) / (IM2-IM1), extrahiert aus c3) und c4); und

   d) die Schritte a) bis c) werden für nachfolgende Zeitintervalle wiederholt und ein statistisches Ausgleichverfahren der bestimmten ZTH-Werte wird implementiert, bis sich ein ZTH-Wert einem gegebenen Wert annähert, der als die äquivalente Netzimpedanz ZTH vom Transformator (10) zum Zähler (13) angenommen wird, und wobei die Gewinnung der ersten und zweiten RMS-Spannungs- und Stromwerte VM1, VM2, IM1, IM2 und der Leistungsfaktor-Werte PF1, PF2, die von dem Zähler (13) gemessen werden, und das Ausführen des Algorithmus automatisch mittels der Rechnervorrichtung durchgeführt werden, die die Daten empfängt oder darauf zugreift.

2. Verfahren gemäß Anspruch 1, wobei die Rechnervorrichtung eine Vorrichtung einer Steuerzentrale ist, wobei eine Verbindung zu einem Kommunikationsmodul des Zählers (13) besteht.

3. Verfahren gemäß Anspruch 2, wobei die Rechnervorrichtung einer Steuerzentrale die äquivalente Impedanz ZTH mit den RMS-Spannungs- und RMS-Stromwerten VM1, VM2, IM1, IM2 und den Leistungsfaktor-Werten PF1, PF2 berechnet, die von dem Zähler (13) gemessen werden, entsprechend den Zeitpunkten $t_1$ und $t_2$, in denen im Zähler (13) keine zusätzliche Eingangsleistung außer der vom Transformator (10) bereitgestellten Leistung vorhanden ist.

4. Verfahren gemäß Anspruch 1, wobei der Algorithmus auf jeden der Zähler (13) einer gegebenen Verteilungsleitung angewendet wird.

**5.** Verfahren gemäß Anspruch 4, wobei die Rechnervorrichtung eine Vorrichtung einer Steuerzentrale ist, wobei eine Verbindung zu einem Kommunikationsmodul jedes der Zähler (13) einer gegebenen elektrischen Stromverteilungsleitung besteht.

**6.** Verfahren gemäß Anspruch 5, wobei die Rechnervorrichtung einer Steuerzentrale die äquivalente Impedanz ZTH mit den RMS-Spannungs- und RMS-Stromwerten VM1, VM2, IM1, IM2 und den Leistungsfaktor-Werten PF1, PF2 berechnet, die von jedem der Zähler (13) der gegebenen Verteilungsleitung gemessen werden, entsprechend den Zeitpunkten $t_1$ und $t_2$, in denen im Zähler (13) keine zusätzliche Eingangsleistung außer der vom Transformator (10) bereitgestellten Leistung vorhanden ist.

**7.** Verfahren gemäß Anspruch 5, wobei die genannten RMS-Spannungs-, RMS-Strom- und Leistungsfaktor-Werte, die von den Zählern (13) gemessen werden, in einem Speicher der Steuerzentrale gespeichert werden.

**8.** Verfahren gemäß Anspruch 6, wobei sich die äquivalente Impedanz ZTH für jeden der Zähler (13) gemäß der Netzkomponente ändert, die von dem Segment geliefert wird, das Unterschiede bezüglich Abstand, Kabeltypen und Zustand des Leiters vom Transformator (10) zum Zähler (13) aufweist.

**9.** Verfahren gemäß Anspruch 1, **dadurch gekennzeichnet, dass** es ferner Folgendes umfasst:

Anschließen eines elektrischen Spannungsmessgeräts an den mindestens einen Transformator (10) oder an mindestens eine elektrische Stromverteilungsleitung (12);
wobei das Messgerät einen ersten RMS-Spannungswert VT1 zum ersten Zeitpunkt $t_1$ und einen zweiten RMS-Spannungswert VT2 zum zweiten Zeitpunkt $t_2$ misst; und
Berücksichtigen der in c3) gemessenen ersten und zweiten RMS-Spannungswerte VT1, VT2, so dass die Thevenin-Spannung VTH zum ersten Zeitpunkt eine Spannung als Ergebnis der Implementierung des folgenden Ausdrucks liefert: ZTH * IM1 + (VM1-VT1) und zum zweiten Zeitpunkt eine Spannung als Ergebnis der Implementierung des folgenden Ausdrucks liefert: ZTH * IM2 + (VM2-VT2),
wobei der Algorithmus den folgenden Ausdruck implementiert: ZTH = ((VM1-VT1) - (VM2-VT2)) / (IM2-IM1).

**Revendications**

**1.** Une méthode pour détecter des impédances dans un réseau de distribution d'électricité , où ce réseau de distribution d'électricité comporte au moins un transformateur d'alimentation (10) ayant une ou plusieurs lignes de distribution d'électricité (12) associées à celui-ci, chaque ligne de distribution d'électricité (12) y ayant associé un ou plusieurs nœuds de distribution d'électricité (11) pour distribuer de l'électricité aux utilisateurs et un ou plusieurs compteurs d'utilisateurs d'électricité (13), **caractérisé en ce que** la méthode comporte les étapes suivantes en utilisant au moins un de ces compteurs d'électricité et un dispositif informatique :

a) le compteur (13) mesurant une première valeur VM1 de tension RMS, une première valeur IM1 de courant RMS et une première valeur de facteur de puissance PF1 dans ce compteur (13) à un premier temps $t_1$, ces valeurs VM1, IM1 et PF1 étant mesurées dans le compteur (13) dû à la consommation d'électricité causée par des charges connectées au compteur (13) ;
b) le compteur (13) mesurant une deuxième valeur VM2 de tension RMS, une deuxième valeur IM2 de courant RMS et une deuxième valeur PF2 de facteur de puissance dans ce compteur (13) à un deuxième temps $t_2$, dans lequel une variation de consommation d'électricité causée par des charges connectées au compteur (13) est détectée par rapport à ce premier temps $t_1$ dans ce compteur (13) ; et
c) exécuter un algorithme qui détermine une valeur de l'impédance ZTH de réseau équivalente de ce transformateur (10), qui est au moins une, au compteur (13) en tenant compte de ce qui suit :

c1) l'impédance ZTH de réseau équivalente est similaire à l'impédance de réseau calculée conformément au théorème de Thevenin.
c2) la tension de tête de réseau de ligne conformément au théorème de Thevenin VTH reste sans changement à ces premier et deuxième temps $t_1, t_2$ ;
c3) la tension de Thevenin VTH offre une tension à ce premier temps $t_1$ comme résultat de la mise en œuvre de l'expression suivante : ZTH*IM1 + VM1, et une tension de ce deuxième temps $t_2$ comme résultat de la mise en œuvre de l'expression suivante : ZTH*IM2 + VM2 ; et
c4) les tensions RMS et les courants VM et RMS IM comprennent des termes complexes dus au réseau de courant alternatif VM = VM*cos(a) + VM*sin(a)*j, et IM = IM*cos(b) + IM*sin(b)*j, où (a) est l'angle entre VTH et VM, et sa valeur est proche de zéro, et b est l'angle entre VTH et IM, et sa valeur est proche d'une valeur du facteur de puissance PF aux temps $t_1$ $t_2$ mesurés par le compteur (13),

où cet algorithme met en œuvre l'expression suivante : ZTH = (VM1 - VM2) / (IM2-IM1), extrait de c3) et c4) ; et

d) répéter les étapes a) à c) pendant des intervalles de temps suivants et mettre en œuvre une procédure d'ajustage statistique des valeurs déterminées ZTH jusqu'à ce qu'une valeur ZTH converge avec une certaine valeur qui est prise comme l'impédance de réseau équivalente ZTH du transformateur (10) au compteur (13), et où l'acquisition de ces première et deuxième valeurs de tension RMS et de courant VM1, VM2, IM1, IM2 et des valeur de facteur de puissance PF1, PF2 mesurées par le compteur (13) et l'exécution de l'algorithme sont faits automatiquement au moyen de ce dispositif informatique, qui reçoit où a accès à ces données.

2. La méthode conformément à la revendication 1, où ce dispositif informatique est un dispositif d'un centre de contrôle ayant une connexion à un module de communication d'un compteur (13).

3. La méthode conformément à la revendication 2, où ce dispositif informatique d'un centre de contrôle calcule l'impédance équivalente ZTH avec les valeurs VM1, VM2, IM1, IM2 de tension RMS et de courant RMS, et les valeurs de facteur de puissance PF1, PF2, mesurées par le compteur (13) correspondant aux temps $t_1$ et $t_2$, dans lesquels il n'y a pas d'électricité entrant complémentaire dans le compteur (13) autre que l'électricité fournie par le transformateur (10).

4. La méthode conformément à la revendication 1, où cet algorithme est appliqué à chacun des compteurs (13) d'une certaine ligne de distribution.

5. La méthode conformément à la revendication 4, où ce dispositif informatique est un dispositif d'un centre de contrôle, ayant une connexion à un module de communication de chacun des compteurs (13) d'une certaine ligne de distribution d'électricité.

6. La méthode conformément à la revendication 5, où ce dispositif informatique d'un centre de contrôle calcule l'impédance équivalente ZTH avec les valeurs VM1, VM2, IM1, IM2 de tension RMS et de courant RMS et les valeurs du facteur de puissance PF1, PF2 mesurées par chacun des compteurs (13) de cette certaine ligne de distribution, correspondant aux temps $t_1$ et $t_2$ dans lesquels il n'y a pas d'électricité entrant complémentaire dans le compteur (13) autre que l'électricité fournie par le transformateur (10).

7. La méthode conformément à la revendication 5, où ces valeurs de tension RMS, de courant RMS et de facteur de puissance mesurées par les compteurs (13) sont stockées dans une mémoire de ce centre de contrôle.

8. La méthode conformément à la revendication 6, où l'impédance équivalente ZTH pour chacun des compteurs (13) varie conformément au composant de réseau fourni par le segment ayant une distance différente, des types de câbles et un état de conducteur différents du transformateur (10) au compteur (13).

9. La méthode conformément à la revendication 1, **caractérisé en ce qu'**en outre elle comporte :

connecter un appareil pour mesurer la tension électrique à ce transformateur (10) qui est au moins un ou à au moins une ligne de distribution d'électricité (12) ;
cet appareil de mesure mesurant une première valeur VT1 de tension RMS au premier temps $t_1$ et une deuxième valeur VT2 de tension RMS à un second temps $t_2$ ; et
tenir compte de ces première et deuxième valeurs VT1, VT2 de tension RMS, mesurées dans c3), de sorte que la tension VTH de Thevenin fournisse à un premier temps une tension comme résultat de mettre en œuvre l'expression suivante : ZTH*IM1 + (VM1 - VT1) et une tension à ce deuxième temps comme résultat de mettre en œuvre l'expression suivante : ZTH*IM2 + (VM2-VT2),
où l'algorithme met en œuvre l'expression suivante: ZTH = ((VM1-VT1) - (VM2-VT2)) / (IM2 - IM1).

**FIG. 1**

**FIG. 2**

A meter measuring a first RMS voltage VM1 value, a first RMS current IM1 value and a first power factor PF1 value at a first time $t_1$ in which consumption is detected in the meter — 301

A meter measuring a second RMS voltage VM2 value, a second RMS current IM2 value and a second power factor PF2 value at a second time $t_2$ in which a variation in consumption is detected with respect to $t_1$ — 302

Running an algorithm that determines a value of the equivalent grid impedance ZTH from the transformer to the meter taking into consideration a series of restrictions and implementing the following expression: ZTH = (VM1-VM2) / (IM2-IM1) — 303

## FIG. 3

| A meter measuring a first RMS voltage VM1 value, a first RMS current IM1 value and a first power factor PF1 value at a first time $t_1$ in which consumption is detected in the meter | 401 |

| A meter measuring a second RMS voltage VM2 value, a second RMS current IM2 value and a second power factor PF2 value at a second time $t_2$ in which a variation in consumption is detected with respect to $t_1$ | 402 |

| An electric voltage measuring apparatus connected to a transformer or to an electrical power distribution line measuring a first RMS voltage VT1 value and a second RMS voltage VT2 value of the head-end of the grid at said times $t_1$ and $t_2$ | 403 |

| Running an algorithm that determines a value of the equivalent grid impedance ZTH from the transformer to the meter taking into consideration a series of restrictions and implementing the following expression: ZTH = ((VM1-VT1) – (VM2-VT2)) / (IM2-IM1) | 404 |

# FIG. 4

**EP 3 642 636 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 20150241488 A1
- CN 102095911 B
- WO 2015179908 A1
- US 2016047851 A1